# EUROPEAN PATENT SPECIFICATION

(11) **EP 3 589 102 B1**
(45) Date of publication and mention of the grant of the patent: **09.02.2022**
(21) Application number: 19181416.9
(22) Date of filing: 20.06.2019
(51) Int. Cl.: H05K 7/20

(54) **HEAT TRANSFER STRUCTURE, POWER ELECTRONICS MODULE, COOLING ELEMENT, METHOD OF MANUFACTURING A HEAT TRANSFER STRUCTURE AND METHOD OF MANUFACTURING A POWER ELECTRONICS COMPONENT**
WÄRMEÜBERTRAGUNGSSTRUKTUR, LEISTUNGSELEKTRONIKMODUL, KÜHLELEMENT, VERFAHREN ZUR HERSTELLUNG EINER WÄRMEÜBERTRAGUNGSSTRUKTUR UND VERFAHREN ZUR HERSTELLUNG EINER LEISTUNGSELEKTRONIKKOMPONENTE
STRUCTURE DE TRANSFERT DE CHALEUR, MODULE ÉLECTRONIQUE DE PUISSANCE, ÉLÉMENT DE REFROIDISSEMENT, PROCÉDÉ DE FABRICATION D'UNE STRUCTURE DE TRANSFERT DE CHALEUR ET PROCÉDÉ DE FABRICATION D'UN COMPOSANT ÉLECTRONIQUE DE PUISSANCE

(30) Priority: 29.06.2018 US 201816023252
(43) Date of publication of application: 01.01.2020
(73) Proprietor: ABB Schweiz AG, 5400 Baden (CH)
(72) Inventor: Manninen, Jorma, 00380 Helsinki (FI); Silvennoinen, Mika, 00380 Helsinki (FI); Ingman, Kjell, 00380 Helsinki (FI)
(74) Representative: Kolster Oy Ab

(56) References cited:
- US-A1- 2004 232 544
- US-A1- 2006 000 591
- US-A1- 2008 079 021

## Description

### FIELD OF THE INVENTION

The present invention relates to a heat transfer structure, power electronics module, cooling element and methods of manufacturing a heat transfer structure and a power electronics component.

### BACKGROUND OF THE INVENTION

Power electronics components, such as single power electronics components or power electronic modules, are commonly used in high powered devices for switching high currents and operating on high voltages. With single power electronics components reference is made to high power thyristors and diodes, for example. Power electronics modules contain multiple of switch components which are situated in a same component housing and typically internally connected to each other to provide a certain circuit structure.

Power electronics modules are used, for example, for producing certain power conversion circuits, such as inverters and converters. An example of a power electronics module contains two IGBTs (Insulated Gate Bi-polar Transistors) which are connected in series inside the module. Other examples may include bridge topologies or parts of bridge topologies which are readily electrically connected inside the module.

Power electronics modules or single power electronics components may also comprise a base plate which is typically made of copper. The purpose of the base plate is to conduct the heat generated by the semiconductors to a cooling device, such as heatsink. The surface of the base plate is typically a substantially planar surface to which a heatsink can be attached. The heatsink is further dimensioned to take into account the amount of heat generated by the semiconductor components in the module.

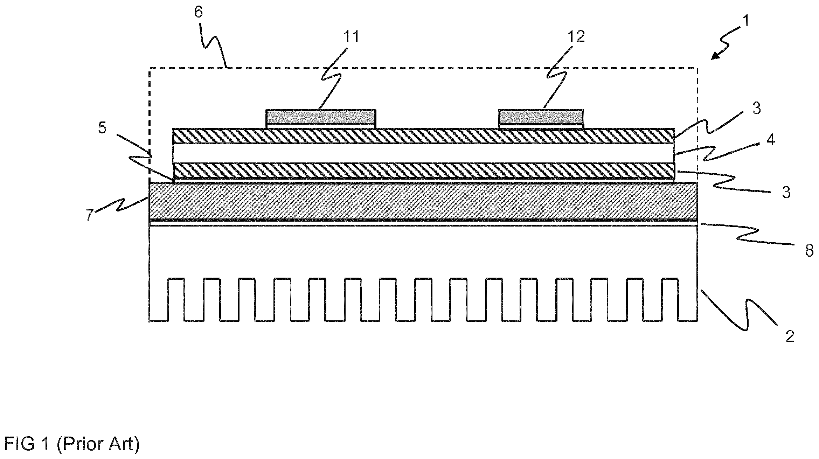

Figure 1 shows an example of a cross-section of a power electronics module 1 attached to a heatsink 2. The power electronics module of the example comprises two semiconductor chips 11, 12 which are soldered to a substrate, such as a direct copper bonding (DCB) structure. The DCB structure of the example has two copper plates 3 and a ceramic layer 4 between the copper plates 3. The DCB structure is soldered with a solder layer 5 on the top of a copper base plate 7 of the module. The module further comprises a housing 6 which is shown with a dash-dot line surrounding the DCB structure and the chips.

The module of the example of Figure 1 is attached to a heatsink such that a thermal interface material 8 is positioned between the base plate of the module and the base plate of the heatsink. The purpose of the thermal interface material is to transfer the heat from the module's base plate to the heatsink as effectively as possible. It should be noted that Figure 1 is provided only to show an example of structure of power electronic module attached to a heatsink. It is clear that other kinds of structures exist.

Power electronics module's internal electronics packing density increases gradually with advanced construction materials and manufacturing methods. This is leading to more challenging module external cooling solutions as devices are able to create very high, over 35 W/cm², hot spots to the heatsink surface.

In view of cooling the situation is most demanding when the module is operated at its maximum current and voltage level i.e. at maximum power. In this condition the conventional aluminium heat sinks' baseplate spreading thermal resistance is too high for the module base plate high heat spots. That is, a conventional aluminium heatsink is not able to spread the heat transferred from the baseplate of the module fast enough. This results in both higher heatsink-to-baseplate temperatures and chip-to-junction temperatures accordingly. Although novel components may allow higher junction temperatures than before due to novel chip material, the component may not be fully utilized unless the power electronics module's external cooling in not at appropriate level.

Common power electronics module external cooling solutions include for example aluminium heat sinks. These conventional solutions are quite sufficient for base plate heat loss densities of typical power electronics modules.

More demanding applications with higher base plate heat loss densities, e.g. over 35 W/cm2, require clearly more effective heat transfer from the base plate. Typically heat transfer is increased for example by increasing cooling air flow rate with larger cooling fans, modifying the aluminium heat sink in different ways like. Modification may include adding a copper heat spreading plate in to the base plate or replacing the heatsink aluminium cooling fins with copper fins. More effective cooling arrangements can be obtained by replacing the aluminium heat sink with heat pipe heat sinks or thermosiphon cooling devices.

Document US2008/079021A1 discloses a heat transfer structure with a metal matrix composite material having a filling content.

Document US2004/0232544A1 discloses a heat transfer structure with anisotropic thermal conductivity.

US2006000591 teaches that the high K inserts are fabricated as a series of slabs that disperse heat being transmitted in the z direction along the xy plane (FIG. 6A). Alternatively or in addition, the high K inserts may include voids, e.g., holes, channels, grooves, slots, etc. that may themselves be filled with a second high K material. The voids may extend part way or all the way through the insert. The walls of the voids may be perpendicular to the surface from which they project or situated at some other angle.

Common challenge for these more efficient heat sink and cooling designs is that their cost is significantly higher than conventional aluminium heat sink's. The cost increase derives from several issues like more laborious manufacturing, more complex manufacturing, and higher price materials. It would thus be beneficial to manage the centralized heat loss density within the power electronics module and this way enable use of relatively low cost heat sink solutions.

### BRIEF DISCLOSURE OF THE INVENTION

"The invention is defined by the features of claims 1 and 8. Further embodiments are defined in the dependent claims.

An object of the present invention is to provide a heat transfer structure, a power electronics module, a cooling element and a method of producing a heat transfer structure and a power electronics module so as to solve the above problems. The objects of the invention are achieved by a heat transfer structure and a method of producing a heat transfer structure which are characterized by what is stated in the independent claims. The preferred embodiments of the invention are disclosed in the dependent claims.

The invention is based on the idea of producing a heat transfer structure which is employed in a power electronics module and cooling element. The heat transfer structure is formed of a metallic body and has a carbon based insert. According to an embodiment, the carbon based insert is formed of carbon based plates or strips and preferably graphite plates or graphene plates. Preferably, the carbon based insert has anisotropic thermal conductivity.

The heat transfer structure is preferably formed such that carbon based insert is partly in the surface of the metallic body. That is, edges of the carbon based plates are at the surface of the metallic body. Optionally, the carbon based insert is fully inside the metallic body.

The heat transfer structure of the invention produces good thermal characteristics. The heat transferred using the metallic body and the heat transfer is enhanced by the carbon based insert. The carbon based insert spreads the heat efficiently inside the metallic body. The thermal properties of the heat transfer structure when employed in a power semiconductor module enable to use the full potential of the power semiconductor switches of the module.

### BRIEF DESCRIPTION OF THE DRAWINGS

In the following the invention will be described in greater detail by means of preferred embodiments with reference to the accompanying drawings, in which
Figure 1 shows a prior art power electronics module attached to a heatsink;
Figure 2 shows cross sections of a prior art power electronics module attached to a heatsink;
Figure 3 shows a flowchart ;
Figure 4 shows a power electronics module according to an embodiment; and
Figure 5 shows a perspective view of an embodiment of the invention.

### DETAILED DESCRIPTION OF THE INVENTION

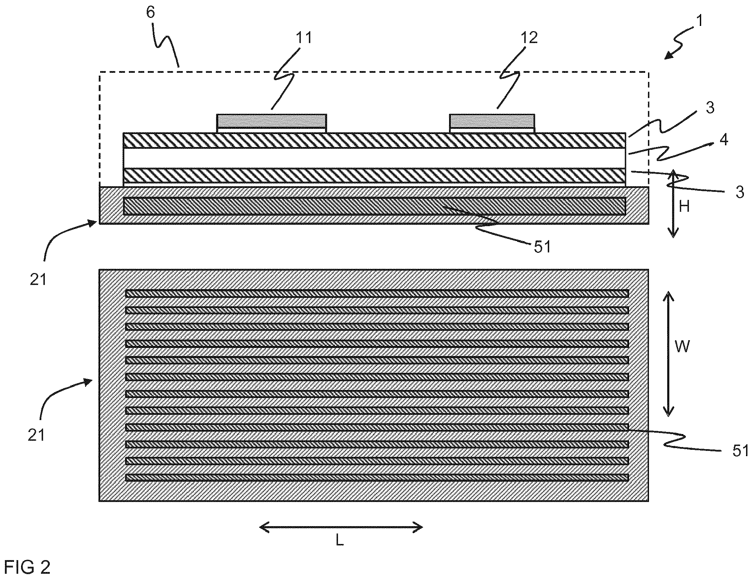

Figure 2 shows cross sectional views of a power electronics module known from US2006/000591.

The upper drawing of Figure 2 shows a cross sectional view as seen from the side of the module and the lower drawing of Figure 2 shows a cross sectional view revealing the inner structure of the base plate of the power electronics module.

According to the present disclosure the power electronics module comprises at least one power electronics component. In the example of Figure 2 two power electronics components 11, 12 are shown. Further, the power electronics module comprises a base plate 21 for transferring heat generated by the at least one power electronics component to a cooling device. The base plate of the disclosure is a heat transfer structure comprising a metallic body having a first surface and a second surface. The first and the second surfaces are opposing surfaces, and one of the first surface and the second surface is adapted to receive a heat generating component. In the disclosure, the metallic body of the heat transfer structure comprises a carbon based insert. In the example of Figure 2, the heat transfer structure is a base plate of a power electronics component.

According to the disclosure, the base plate is a metallic structure with a carbon based insert. The base plate of a power electronics module is a structure that is fastened to a substrate 3,4 of the module and thus a part of the module. One outer surface of a power electronics module is formed of a surface of the base plate, and a cooling device, such as a heatsink, is attached to the surface of the base plate during installation of an electrical device.

Optionally, the carbon based insert has anisotropic thermal conductivity. With anisotropic thermal conductivity it is referred to a structure which transfers heat more efficiently in one direction than to another direction. Further, according to an embodiment, the thermal conductivity of the core structure of the base plate is highest in a plane defined by the directions of length and height of the base plate. The direction of length being defined as the direction of the longest dimension of the heat transfer structure L and the direction of height H being defined as the direction of normal of the surface of the heat transfer structure. Thus, when the thermal conductivity is highest in a plane defined by the directions of length and height of the base plate, heat is transferred efficiently in the direction of length and height of the base plate. This means further that the heat is not transferred as efficiently in the direction opposite to the mentioned plane, i.e. in the direction of width of the base plate.

According to an embodiment, the carbon based insert comprises carbon based material plates 51 which are arranged at least partly inside the metallic body of the heat transfer structure. The metallic body of heat transfer structure is a copper structure. According to an embodiment carbon based material plates 51 have a length, a width and a height. The length of the carbon based material plates being the greatest dimension and the height being the smallest dimension of the carbon based material plates. The carbon based material plates are further arranged parallel inside the metallic body, such that the direction of length of carbon based material plates correspond to the direction of length of the metallic body and the direction of width of carbon based material plates correspond to the direction of height of the metallic body. With the embodiment, the thermal conductivity of the heat transfer structure is highest in the direction of length of the metallic body and in the direction of height of the metallic body as the carbon based material plates have the longest dimensions in those directions. In Figure 2 the carbon based material plates are shown completely enclosed by the metallic body. However, the carbon based material plates or strips may be positioned such that one edge of the carbon based material plates are in the surface of the metallic body. That is, the carbon based material plates have one edge which forms part of one surface of the heat transfer structure. In Figure 2 the carbon based material plates 51 are shown inside the metallic body. Another option would thus be that the carbon based material plates are in connection with the surface which is connected to a DCB structure 3, 4. or with a cooling structure like a heat sink. Naturally, a thermal interface material layer may be employed between a power electronics module and a heat sink, and thus the edges of the carbon based material plates may be in contact with the thermal interface material layer.

When the semiconductor components of a power electronics module are used, the losses in the components or chips 11, 12 generate heat. The heat is transferred through the DCB structure 3, 4 to the base plate. The base plate of the disclosure having a carbon based insert spreads the heat effectively inside the base plate and thus prevents formation of hot-spots in the base plate in the footprint area of the semiconductor chips. With the footprint area of the chips it is referred to the surface area that is directly below chips.

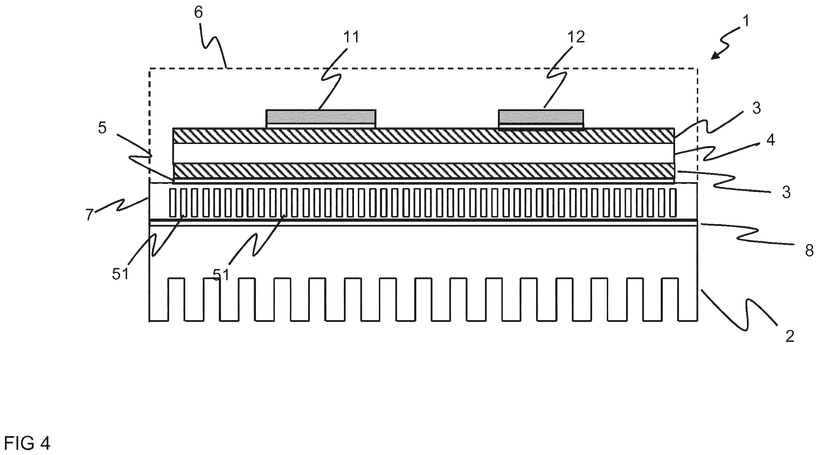

Figure 4 shows an embodiment with the carbon based material plates 51 inside the base plate. The carbon based material plates are preferably graphite or graphene and may be synthetic or natural graphite or graphene. Further, the plates may be of pyrolytic graphene or graphite. Figure 4 shows a cross section of the power electronics module and shows thus the height and width dimensions of the carbon based material plates. The plates or strips are arranged parallel to each other and they extend in the direction of the length of the power electronics module. As shown in Figure 4, the plates 51 inside the metallic structure of the heat transfer structure are at a distance from each other. Further, the carbon based material plates are further evenly spaced inside the heat transfer structure. The corresponding parts of the module are numbered with the same number as in connection with Figure 1. As mentioned, Figures 2 and 4 show embodiments in which the heat transfer structure of the disclosure is employed in a power electronics module.

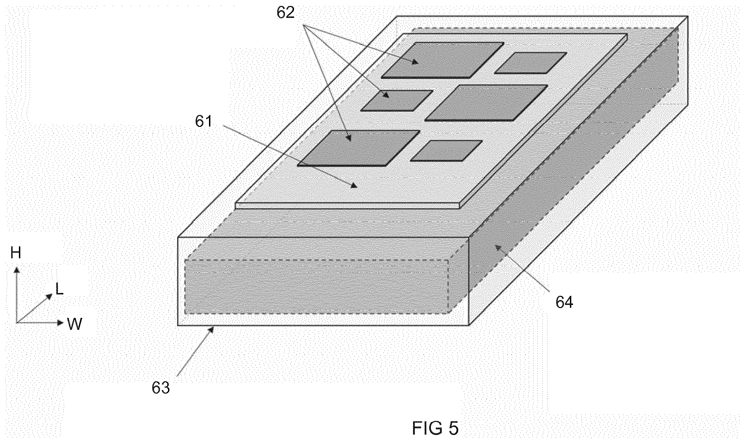

Figure 5 shows a simplified perspective view of a power electronics module with six power electronics semiconductor components 62 on a substrate, such as a direct copper bonded structure 61. The DCB structure 61 is attached to a base plate 63 having a carbon based insert 64. The carbon based insert 64 is shown in simplified manner as a block. It is, however clear, that the core structure is, for example, formed of carbon based material plates which extend parallel in the direction of length L of the power electronics module.

The heat transfer structure of the disclosure may also employed as a cooling element comprising a heat receiving body. The heat receiving body is a metallic body having a first surface and a second surface, which surfaces are opposing surfaces. Further, in the cooling element of the disclosure, one of the first surface and the second surface is adapted to receive a heat generating component, and the metallic body comprises a carbon based insert. The structure of the cooling element of the disclosure corresponds to that of the base plate described above in detail. The cooling element may be heat sink having cooling fins for transferring the heat to surrounding air or a liquid cooled element in which a liquid, such as water, is circulated for removing the heat.

The heat transfer structure may also be structured as a combination of a cooling element and base plate of a power electronics module. In such a structure the heat transfer element is employed as a base plate of a power electronics module as described in detail above. Further, another surface of the metallic body may be furnished with cooling fins or openings for fluid, that can be either gas or liquid, circulation for removing heat from the base plate. In such a structure efficient thermal properties are obtained with a single structure, i.e. without separate cooling element attached to the base plate.

The carbon based material plates may be separate plates or strips which are arranged in parallel inside the metallic, preferably copper, base plate. The carbon based material plates may also be provided as a larger entity having two or multiple of plates attached to each other. For example, all of the carbon based material plates may be attached to each other in one end of the plates. The plates may be attached to each other also from the center of the plates or in any other position of the plates.

The bottom surface of the base plate is adapted to receive a cooling device in thermally conductive manner such that the heat from the semiconductor components or chips is led through the base plate to the cooling device such as a heat sink. As the heat is spread effectively in the base plate, the cooling device does not have to be as effective as in the case with the known base plates. Use of a separate cooling device may also be used although above described combination of base plate and heat sink is possible.

Desirably, the at least one power electronics component is an insulated gate bipolar transistor (IGBT). IGBT components are widely used in power electronics applications.

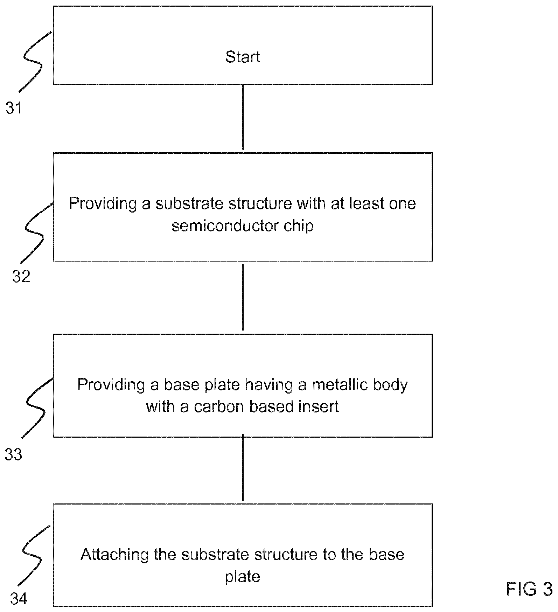

In the method of manufacturing a power electronics module and as shown in the flowchart of Figure 3, a direct copper bonding structure which is a substrate structure with at least one semiconductor chip is provided according to claim 8.

With the method of the invention, a power electronics module is obtained which has the benefits and properties described above.

According to an embodiment of the invention, the metallic body is a copper body. Further, according to a further embodiment, the carbon based insert is formed of carbon based material plates which are arranged parallel and at distance from another according to claim 1.

In the above, the invention is described in connection with a power electronics module. As it understood, the power electronics module of the disclosure comprises a base plate which is structured as a heat transfer structure of the present disclosure. Further, the cooling element of the disclosure comprises corresponding heat transfer structure as described in connection with the power electronics module.

It will be obvious to a person skilled in the art that, as the technology advances, the inventive concept can be implemented in various ways. The invention and its embodiments are not limited to the examples described above but may vary within the scope of the claims.

## Claims

1. A heat transfer structure, wherein the structure comprises a metallic body having a first surface and a second surface, wherein
the first surface and the second surface are opposing surfaces,
one of the first surface and the second surface is adapted to receive a heat generating component, and wherein
the metallic body comprises a carbon based insert, **characterized in that**
the metallic body is a copper structure and the carbon based insert comprises carbon based material plates (51) arranged inside the copper structure (7), and
the carbon based material plates (51) have a length, a width and a height, the length being the greatest dimension and the height being the smallest dimension of the plates, wherein the carbon based material plates are arranged parallel inside the metallic body, such that the direction of length of carbon based material plates correspond to the direction of length of the metallic body and the direction of width of carbon based material plates correspond to the direction of height of the metallic body.

2. A power electronics module comprising at least one power electronics component (11, 12), wherein the power electronics module comprises a heat transfer structure according to claim 1, wherein the metallic body is a base plate (7) of the power electronic module for transferring heat generated by the at least one power electronics component to a cooling device.

3. A power electronics module according to claim 2, wherein the carbon based material plates (51) are of graphite or graphene.

4. A power electronics module according to claim 3, wherein the graphite or graphene is synthetic graphite or graphene.

5. A power electronics module according to claim 2, wherein the parallel arranged carbon based material plates (51) are at a distance from each other and are connected to each other from one end of the plates.

6. A cooling element comprising a heat receiving body, wherein the heat receiving body comprises a heat transfer structure according to claim 1, wherein the metallic body is the heat receiving body.

7. A cooling element according to claim 6, wherein another one of the first surface and the second surface comprises cooling fins and/or openings for fluid circulation.

8. A method of manufacturing a power electronics module, the method comprising
providing a substrate structure (3, 4) with at least one semiconductor chip,
providing a base plate (7) having a metallic body with a carbon based insert,
and
attaching the substrate structure (3, 4) to the base plate (7), **characterized in that**
the metallic body is a copper structure and the carbon based insert comprises carbon based material plates (51) arranged inside the copper structure, and
the carbon based material plates have a length, a width and a height, the length being the greatest dimension and the height being the smallest dimension of the plates, wherein the carbon based material plates are arranged parallel inside the metallic body, such that the direction of length of carbon based material plates correspond to the direction of length of the metallic body and the direction of width of carbon based material plates correspond to the direction of height of the metallic body.

## Patentansprüche

1. Wärmeübertragungsstruktur, wobei die Struktur einen metallischen Körper mit einer ersten Oberfläche und mit einer zweiten Oberfläche umfasst, wobei
die erste Oberfläche und die zweite Oberfläche gegenüberliegende Oberflächen sind,
eine der ersten Oberfläche und der zweiten Oberfläche eingerichtet ist, um eine Wärme erzeugende Komponente aufzunehmen, und wobei
der metallische Körper einen auf Kohlenstoff basierenden Einsatz umfasst, **dadurch gekennzeichnet, dass**
der metallische Körper eine Kupfer-Struktur ist und der auf Kohlenstoff basierende Einsatz Platten (51) aus auf Kohlenstoff basierendem Material umfasst, die in der Kupfer-Struktur (7) angeordnet sind, und
die Platten (51) aus auf Kohlenstoff basierendem Material eine Länge, eine Breite und eine Höhe aufweisen, wobei die Länge die größte Abmessung ist und die Höhe die kleinste Abmessung der Platten ist, wobei die Platten aus auf Kohlenstoff basierendem Material derartig parallel in dem metallischen Körper angeordnet sind, dass die Richtung der Länge der Platten aus auf Kohlenstoff basierendem Material der Richtung der Länge des metallischen Körpers entspricht und die Richtung der Breite der Platten aus auf Kohlenstoff basierendem Material der Richtung der Höhe des metallischen Körpers entspricht.

2. Leistungselektronikmodul, mindestens eine Leistungselektronikkomponente (11, 12) umfassend, wobei das Leistungselektronikmodul eine Wärmeübertragungsstruktur nach Anspruch 1 umfasst, wobei der metallische Körper eine Basisplatte (7) des Leistungselektronikmoduls zum Übertragen von Wärme, die durch die mindestens eine Leistungselektronikkomponente erzeugt wird, an eine Kühlvorrichtung ist.

3. Leistungselektronikmodul nach Anspruch 2, wobei die Platten (51) aus auf Kohlenstoff basierendem Material aus Graphit oder Graphen sind.

4. Leistungselektronikmodul nach Anspruch 3, wobei der Graphit oder das Graphen synthetischer Graphit oder synthetisches Graphen ist.

5. Leistungselektronikmodul nach Anspruch 2, wobei die parallel angeordneten Platten (51) aus auf Kohlenstoff basierendem Material in einem Abstand voneinander sind und von einem Ende der Platten miteinander verbunden sind.

6. Kühlelement, einen Wärme aufnehmenden Körper umfassend, wobei der Wärme aufnehmende Körper eine Wärmeübertragungsstruktur nach Anspruch 1 umfasst, wobei der metallische Körper der Wärme aufnehmende Körper ist.

7. Kühlelement nach Anspruch 6, wobei eine andere der ersten Oberfläche und der zweiten Oberfläche Kühlrippen und/oder Öffnungen zur Fluidzirkulation umfasst.

8. Verfahren zum Herstellen eines Leistungselektronikmoduls, das Verfahren Folgendes umfassend
Bereitstellen einer Substratstruktur (3, 4) mit mindestens einem Halbleiterchip,
Bereitstellen einer Basisplatte (7) mit einem metallischen Körper mit einem auf Kohlenstoff basierenden Einsatz,
und
Befestigen der Substratstruktur (3, 4) an der Basisplatte (7), **dadurch gekennzeichnet, dass**
der metallische Körper eine Kupfer-Struktur ist und der auf Kohlenstoff basierende Einsatz Platten (51) aus auf Kohlenstoff basierendem Material umfasst, die in der Kupfer-Struktur angeordnet sind, und
die Platten aus auf Kohlenstoff basierendem Material eine Länge, eine Breite und eine Höhe aufweisen, wobei die Länge die größte Abmessung ist und die Höhe die kleinste Abmessung der Platten ist, wobei die Platten aus auf Kohlenstoff basierendem Material derartig parallel in dem metallischen Körper angeordnet sind, dass die Richtung der Länge der Platten aus auf Kohlenstoff basierendem Material der Richtung der Länge des metallischen Körpers entspricht und die Richtung der Breite der Platten aus auf Kohlenstoff basierendem Material der Richtung der Höhe des metallischen Körpers entspricht.

## Revendications

1. Structure de transfert de chaleur, la structure comprenant un corps métallique possédant une première surface et une deuxième surface,
la première surface et la deuxième surface étant des surfaces opposées,
l'une parmi la première surface et la deuxième surface étant adaptée pour recevoir un composant de génération de chaleur, et
le corps métallique comprenant un insert à base de carbone, **caractérisée en ce que**
le corps métallique est une structure de cuivre et l'insert à base de carbone comprend des plaques (51) de matériau à base de carbone agencées à l'intérieur de la structure de cuivre (7), et
les plaques (51) de matériau à base de carbone possédant une longueur, une largeur et une hauteur, la longueur étant la plus grande dimension et la hauteur étant la plus petite dimension des plaques, les plaques de matériau à base de carbone étant agencées parallèlement à l'intérieur du corps métallique, de sorte que la direction de longueur des plaques de matériau à base de carbone corresponde à la direction de longueur du corps métallique et la direction de largeur des plaques de matériau à base de carbone corresponde à la direction de hauteur du corps métallique.

2. Module électronique de puissance comprenant au moins un composant électronique de puissance (11, 12), le module électronique de puissance comprenant une structure de transfert de chaleur selon la revendication 1, le corps métallique étant une plaque de base (7) du module électronique de puissance pour transférer de la chaleur générée par l'au moins un composant électronique de puissance à un dispositif de refroidissement.

3. Module électronique de puissance selon la revendication 2, les plaques (51) de matériau à base de carbone étant composées de graphite ou de graphène.

4. Module électronique de puissance selon la revendication 3, le graphite ou graphène étant un graphite ou graphène synthétique.

5. Module électronique de puissance selon la revendication 2, les plaques (51) de matériau à base de carbone agencées parallèlement étant à une distance l'une de l'autre et étant connectées l'une à l'autre à partir d'une extrémité des plaques.

6. Élément de refroidissement comprenant un corps de réception de chaleur, le corps de réception de chaleur comprenant une structure de transfert de chaleur selon la revendication 1, le corps métallique étant le corps de réception de chaleur.

7. Élément de refroidissement selon la revendication 6, une autre parmi la première surface et la deuxième surface comprenant des ailettes de refroidissement et/ou des ouvertures pour une circulation de fluide.

8. Procédé de fabrication d'un module électronique de puissance, le procédé comprenant
la mise à disposition d'une structure de substrat (3, 4) comportant au moins une puce semiconductrice,
la mise à disposition d'une plaque de base (7) possédant un corps métallique doté d'un insert à base de carbone,
et
la fixation de la structure de substrat (3, 4) à la plaque de base (7), **caractérisé en ce que**
le corps métallique est une structure de cuivre et l'insert à base de carbone comprend des plaques (51) de matériau à base de carbone agencées à l'intérieur de la structure de cuivre, et
les plaques de matériau à base de carbone possèdent une longueur, une largeur et une hauteur, la longueur étant la plus grande dimension et la hauteur étant la plus petite dimension des plaques, les plaques de matériau à base de carbone étant agencées parallèlement à l'intérieur du corps métallique, de sorte que la direction de longueur des plaques de matériau à base de carbone corresponde à la direction de longueur du corps métallique et la direction de largeur des plaques de matériau à base de carbone corresponde à la direction de hauteur du corps métallique.
